# DEMANDE DE BREVET EUROPEEN

(11) **EP 2 709 143 A1**
(43) Date de publication de la demande: **19.03.2014**
(21) Numéro de dépôt: 12306128.5
(22) Date de dépôt: 18.09.2012
(51) Int. Cl.: H01L 21/56, H01L 23/31

(54) **Procédé de moulage pour fabriquer un boîtier électronique**

(71) Demandeur: Gemalto SA, 92190 Meudon (FR)
(72) Inventeur: Ottobon, Stéphane, 83270 SAINT CYR SUR MER (FR); Dossetto, Lucile, 83270 SAINT CYR SUR MER (FR); Audouard, Laurent, 13400 AUBAGNE (FR); Guijarro, Sébastien, 13600 LA CIOTAT (FR)

(57) **Abrégé**

L'invention concerne un procédé pour fabriquer un boîtier électronique (1A, 1A, 1C) comprenant une puce (2) électronique dans le boîtier, une face (3) comportant au moins un jeu de métallisations conductrices (4), ledit procédé comportant les étapes suivantes:
- fourniture ou réalisation d'au moins un jeu de métallisations (4) comprenant des plages ou pistes de circuit conductrices, sur un côté (9) d'un support (5),
- report et connexion d'une puce (2) à chaque jeu de métallisations,
- surmoulage de chaque puce (1) avec son jeu de métallisations sur le support avec une matière (7) de moulage pour réaliser au moins un boîtier,
- séparation du boîtier de son support,
caractérisé en ce que le côté (9) du support (5) au contact des métallisations comporte un adhésif ou est de faible adhésivité et en ce que le surmoulage est effectué à la dimension finale du boîtier.

L'invention concerne également un équipement de moulage et le boîtier obtenu

## Description

### Domaine de l'invention.

L'invention concerne un procédé de moulage pour fabriquer un boîtier électronique comportant une puce et/ou un composant électronique ainsi que le boîtier obtenu.

L'invention concerne également la fabrication de modules de télécommunication pour machines, notamment de type M2M, qui peuvent avoir différents facteurs de forme.

On peut trouver de tels boîtiers par exemple sous la forme de modules pour cartes à puce, aux facteurs de forme divers tels que ceux de petits objets électroniques de formats micro-SD (*Secure Digital* en langue anglaise), Micro-SIM (*Subscriber Identity Module* en langue anglaise) ou Plug-in SIM, Mini UICC (*Universal Integrated Circuit Card* en langue anglaise). On peut trouver en outre toute une gamme de boîtiers permettant le montage de composants en surface (CMS ou SMD) ainsi que des boîtiers de type BGA (*Ball Grid Array* en langue anglaise) comportant des billes de connexion. Ces boîtiers comprennent une interface d'alimentation et/ou de communication notamment à contacts électriques ou à antenne.

L'invention concerne plus particulièrement, mais de manière non limitative, la fabrication d'objets électroniques portables sécurisés comme des cartes ou modules à puce qui trouvent notamment leurs applications dans la santé, la banque, les télécommunications ou encore le contrôle d'identité, le contrôle d'accès physique et/ou logique.

### Art antérieur.

Les techniques connues pour fabriquer de tels objets nécessitent un procédé parfois lent, complexe et peu adaptable parmi lesquelles on trouve principalement les étapes suivantes:
- Définition d'un rouleau de circuit imprimé spécifique ;
- Découpe mécanique dudit circuit imprimé ou gravure chimique pour définir une forme de contacts ;
- Découpe dans un diélectrique pour créer des puits de connexion ;
- Contre-collage du diélectrique sur le circuit imprimé ;
- Métallisation de plots de contacts ;
- Collage d'une ou plusieurs puces d'épaisseurs variables ;
- Câblage à l'aide de fils pour interconnecter lesdites puces et relier les points de contact ;
- Enrobage sous une résine de protection, etc.

Aujourd'hui, les boitiers sont généralement assemblés sur un même support à partir d'un substrat en circuit imprimé (PCB ou «Lead frame») sur lequel sont collés, soudés et surmoulés plusieurs boitiers. La séparation de ces boitiers moulés nécessite une étape de séparation par découpe à l'aide de tout type de procédé de découpe (sciage mécanique, poinçonnage, laser, jet d'eau). Cette étape engendre une grande part du coût de fabrication. D'autre part, l'épaisseur ou encombrement des boitiers actuels étant en constante diminution pour permettre une plus grande intégration dans les appareils portatifs, téléphone, il est nécessaire à cet effet, de prévoir un procédé de fabrication ou agencement plus adapté des boîtiers.

Problème technique.

L'invention a pour objectif de répondre aux inconvénients précités de coût de fabrication et/ou d'encombrement.

Résumé de l'invention.

Le principe de l'invention repose sur un moulage d'un substrat particulier, décrit ci-dessous, dans lequel les contacts ou pistes de circuit ou interfaces d'alimentation et/ou communication vont se détacher d'un support de faible adhésion (ou dont l'adhésion peut être altérée ultérieurement pour permettre une séparation du substrat d'un bloc) et être transférés dans un moulage.

A cet effet, l'invention a pour objet un procédé pour fabriquer un boîtier électronique comportant une puce électronique dont une face comprend au moins des métallisations conductrices, ledit procédé comportant les étapes suivantes:
- fourniture ou réalisation d'au moins un jeu de métallisations comprenant des plages ou pistes de circuit conductrices, sur un côté du support;
- report et connexion d'une puce à chaque jeu de métallisations,
- surmoulage de chaque puce sur son support,
- séparation du boîtier de son support;

Le procédé est **caractérisé en ce que** le support comporte un adhésif ou présente une adhésivité faible par nature ou altérable et en ce que le moulage est effectué à la dimension finale du boîtier.

L'invention a également pour objet un équipement de moulage selon les revendications 7 à 8 ainsi que le boîtier électronique obtenu selon la revendication 9.

Brève description des figures.
- Les figures 1 à 7 illustrent un procédé de fabrication d'un boîtier électronique selon un mode de mise en oeuvre de l'invention ;
- Les figures 8 à 12 illustrent une installation et un procédé de fabrication conformes à un second mode de mise en oeuvre de l'invention ;
- La figure 13 illustre différentes vues d'objets /boîtiers obtenus selon l'un des modes de mise en oeuvre de l'invention.

### Description.

Le procédé de l'invention selon le premier mode de mise en oeuvre, comporte une étape de fourniture ou de réalisation d'au moins un jeu de métallisations comprenant des plages ou pistes de circuit conductrices réalisant une interface de communication et/ou d'alimentation notamment à contacts électriques et/ou à antenne radiofréquence, sur un support adhésif ou de faible adhésivité;

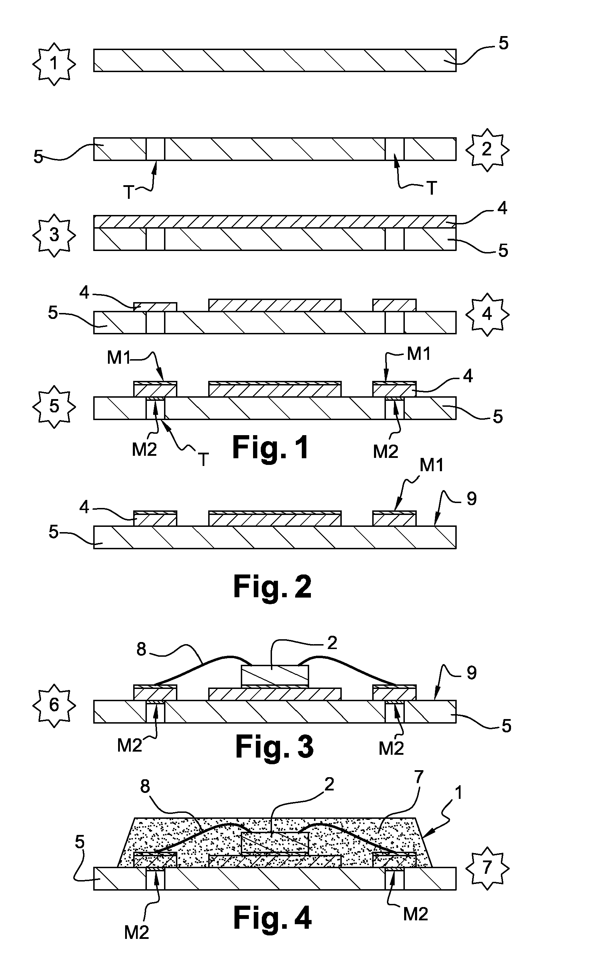

Dans l'exemple à la figure 1 (opérations 1 à 5), est illustré une étape de réalisation d'au moins un jeu de métallisations 4 comprenant des contacts en cuivre sur un substrat 5 détachable / séparable. Le substrat ou support est un film diélectrique choisi pour ses propriétés de faible adhésion de façon à ce que le moulage se détache facilement comme par exemple un PET (polyéthylène téréphtalate), un PEN (Polyéthylène naphthalate), un substrat peu cher du type papier.

Dans le cas d'une antenne, celle-ci peut être réalisée à plat sous forme de spirale. La description est faite préférentiellement pour des métallisations à contacts électriques mais l'invention peut s'appliquer également à d'autres éléments conducteurs électriques tels que pistes, antennes.

Dans toute la description, l'interface à contacts 4 peut être remplacée par une interface radiofréquence à antenne.

De préférence, le support (5) est déterminé avec une pluralité de zones destinée à recevoir chacune un jeu de métallisations et un boîtier.

Dans le cas ou les métallisations de surface sont réalisées à l'aide d'un procédé faisant intervenir des pistes d'amenées de courant, on prendra soin à ce que ces pistes soient peu nombreuses et aient une configuration facilitant leur découpe / séparation lors de la séparation des boitiers avec le support de faible adhésivité, par exemple en ayant une forme de striction, ou prédécoupe ou réduction de section à l'endroit où elles doivent être sectionnées.

Par la suite, on verra que l'adhésif peut être selon les variantes du procédé, un adhésif peu adhérent de par sa nature ou dégradable à la chaleur ou dégradable aux UV (ultraviolets) de façon à ce que chaque jeu de métallisations notamment en cuivre se détache facilement. Les valeurs de faible adhésivité pour que les métallisations et le moulage puissent se détacher du support peuvent être typiquement comprises entre 0,5 et 5 Newton /cm au test de résistance au pelage à 90 degrés. La vitesse de pelage peut être par exemple de 30 cm /minute ou plus.
- A l'opération 1 et 2, le diélectrique adhésivé (ou de faible adhésivité) est percé notamment par poinçonnage ;
- A l'opération 3, on effectue une fixation provisoire notamment par lamination d'une feuille conductrice, notamment en cuivre sur le support diélectrique;
- A l'opération 4, on effectue une gravure chimique de la feuille conductrice pour réaliser la forme des contacts externes du boîtier ou du circuit souhaité ;
- A l'étape 5, on peut effectuer de préférence, un traitement de surface M1, M2 des parties en cuivre, par exemple en NI / Pd/ Au ;

Ce traitement de surface notamment de métallisation (anti-oxydation, passivation) M1 et/ou M2 peut se faire sur les deux faces du cuivre également à travers chaque trou T du support de façon à ce que les contacts externes affleurent sensiblement la surface externe du boitier (à l'épaisseur de la couche de traitement près ou de la couche d'adhésif du support près visée infra).

Si le substrat est faiblement adhésif comme décrit infra, le traitement de surface (métallisation de traitement) ne dépasse que légèrement le niveau de la surface de surmoulage.

Si le substrat comporte ou non une couche de colle comme décrit infra dans une variante, la couche M2 du traitement de surface comprenant une métallisation de traitement dans le trou du support (à distinguer de la métallisation 4 du support) peut avoir un niveau supérieur au niveau de surface de la face 3 du surmoulage.

Selon l'un quelconque des modes de mise en oeuvre, on peut prévoir une adhésion de la métallisation qui soit plus importante au contact de la résine de moulage. L'adhésion peut être obtenue par différents procédés connus: par exemple, en augmentant la rugosité du cuivre du circuit, par l'augmentation de la rugosité de surface (la métallisation additionnelle type Ni /Pd /Au (nickel, palladium, or) suivra cette rugosité, par plasma avant moulage, par points d'ancrage du moulage dans des parties conductrices des métallisations.

Selon une variante de mise en oeuvre, le substrat ci-dessus peut être non poinçonné, comme illustré à la figure 2 ; Dans ce cas, les contacts externes 4 peuvent rester en cuivre (éventuellement protégés de l'oxydation par une passivation organique ou autre traitement de surface préalable ou ultérieur).

Selon une autre variante de mise en oeuvre, le substrat ci-dessus peut être poinçonné, comme illustré à la figure 1, d'un nombre de trous supérieur à ceux nécessaires à être métallisés ceci afin de faciliter la séparation ultérieure du support de faible adhésivité du boitier, la surface en vis-à-vis étant en effet plus faible

Alternativement, les plages de contact peuvent être perforées pour limiter l'adhésion et pour économiser les métallisations et/ou permettre une perméabilité électromagnétique dans le cas où l'objet comprend également une antenne radiofréquence, par exemple gravée sur le support.

Le cas échéant, on réalise une antenne (non représentée) par exemple au même niveau que les contacts ou pistes conductrices, notamment en périphérie et/ou au centre des plages de contacts 4 dans une zone centrale 40. L'antenne, qui peut être une antenne notamment active ou passive (antenne relais) peut éventuellement être imprimée sur la matière de moulage en surface principale avant ou arrière de la matière de moulage.

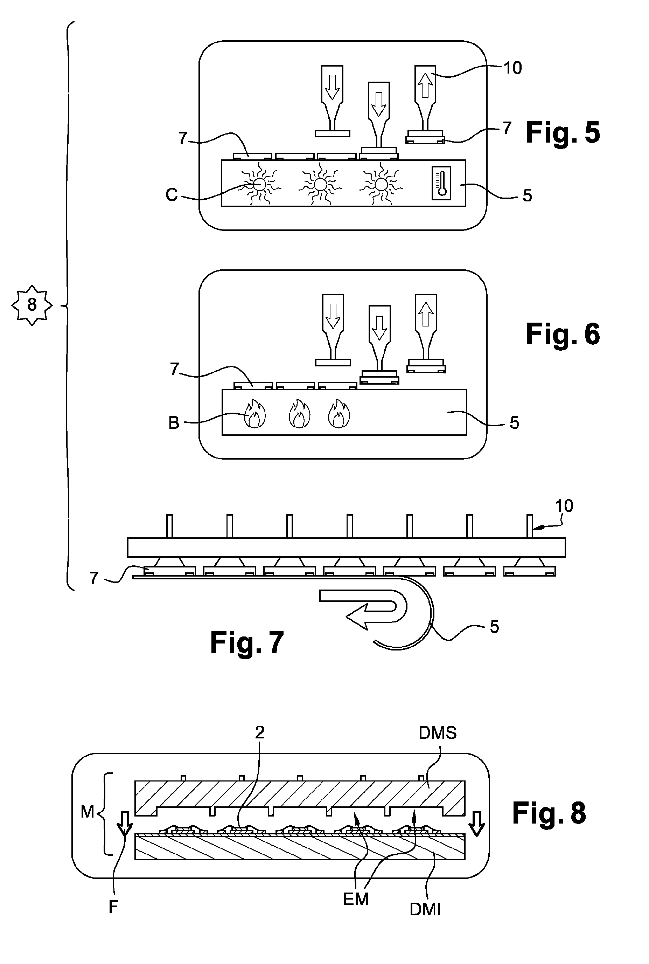

Selon une alternative à l'opération de gravure préférée dans l'invention, on peut prévoir de fixer ou d'imprimer une grille conductrice électriquement (notamment par jet de matière conductrice) sur le support pour former des contacts électriques et/ou des pistes et/ou au moins une antenne.
- A l'opération 6 (fig. 3), on procède au report d'une puce électronique 2 à circuits intégrés sur le support ou les éléments conducteurs (plages, pistes, spires d'antenne);
- A l'opération 6bis facultative (non représentée), avant ou après la fixation de la puce notamment par collage, on peut utiliser un plasma de nettoyage optionnel pour améliorer l'adhésion de la résine de moulage sur les contacts métallisés ;
- A l'opération 7 (fig. 4), on procède au moulage à la dimension finale du boîtier 1 avec une matière de surmoulage isolante 7;
- A l'opération 8 (fig. 5, 6, 7), on procède à une séparation du boitier 1 ses contacts (ou matière de surmoulage 7), du substrat (différentes variantes sont exposées ci-après) ;

De préférence, le support (5) est déterminé avec une pluralité de zones de réception de boîtiers pour réaliser une pluralité de boîtiers en série.

On peut alors, procéder sur un tel support, à une saisie des boitiers notamment par ventouses 10V (fig. 5, 6) disposées sur des préhenseurs mobiles 10 robotisés après avoir chauffé « C » le support, notamment par lampes à infra rouge, pour dégrader l'adhésion de l'adhésif maintenant provisoirement les boîtiers sur le support 5 et permettre ainsi la séparation du boitier 1 avec son jeu de métallisations (contacts, pistes), par rapport au support 5; L'adhésif peut être une adhésif thermoplastique ou thermo fusible.

En alternative (fig. 6), on peut effectuer une destruction du support notamment brûlage « B » (cas notamment d'un substrat en papier 25); On peut également effectuer une séparation des boîtiers individuels par pelage du substrat 5 (fig. 7), les boitiers étant maintenus par aspiration sur des buses 10.
- Aux figures 8 à 12 on décrit une installation et un procédé de fabrication conformes à un second mode de mise en oeuvre de l'invention.

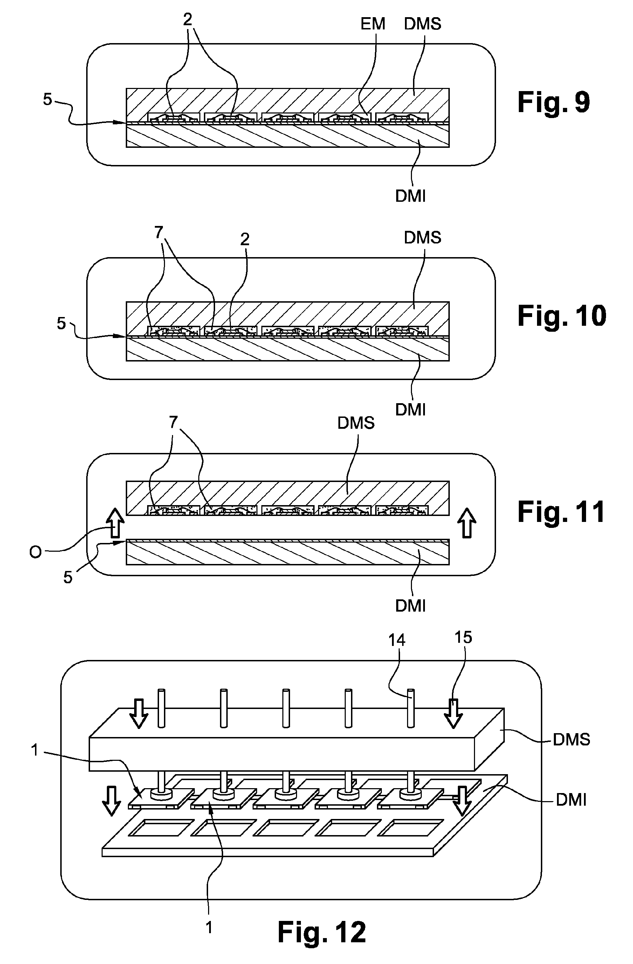

On a recours à un moule M (fig. 8), comprenant une première partie inférieure DMI pour supporter le substrat ou support 5 et une seconde partie supérieure DMS correspondante comportant une pluralité de cavités de moulage (EM) aux dimensions et formes correspondantes aux objets / boîtiers à obtenir.
- A la figure 9, le moule DMS, DMI est refermé suite au déplacement (F) de la partie supérieure DMS contre la partie inférieure DMI et contre le substrat 5. Une pluralité d'espaces de moulage (EM) correspondant aux cavités de moulage CM est définie au dessus du substrat et de la pluralité de puces électroniques.
- A la figure 10, on injecte de la matière dans les espaces de moulage pour surmouler chaque puce électronique et former chaque boîtier. Le moule comporte de manière connue (non représentée) un ou plusieurs point(s) d'injection de matière dans chaque cavité de moulage (EM), par exemple sur les parois de chaque cavité correspondant à une tranche des objets ou face arrière (opposée à la face 3 portant les contacts 4) ;
- A la figure 11, la partie supérieure DMS du moule s'éloigne (O) de la partie inférieure pour ouvrir le moule, le support ou substrat 5 étant maintenu sur la partie inférieure DMI du moule notamment par aspiration. Tout autre moyen de maintien ou de traction notamment mécanique exerçant une force de séparation du support 5 par rapport aux boitiers lors de l'ouverture du moule peut être envisagé.

Les boitiers moulés peuvent rester dans des cavités (EM) ou compartiments du moule (fig. 11) lors de la remontée (O) de la partie supérieure du moule ; Des éjecteurs 14 coulissent (15) dans la partie supérieure du moule DMS au dessus des boitiers et contre leur face arrière, à travers chaque cavité de moulage (EM), pour extraire les boîtiers de leur cavité et tomber dans un bol de récupération ou directement dans un plateau dédié ayant des alvéoles de réception des boitiers (fig.12).

La délamination des boitiers sur le substrat est facilité car le moulage s'effectue à haute température (environ 180°C) et l'adhésif a été choisi pour se dégrader aux environs de cette température. Des éjecteurs 14 coulissant sur la partie haute DMS du moule, peuvent maintenir ce substrat sur la partie basse du moule DMI.

On peut procéder de la manière ci-après. Le support portant les métallisations et au moins une puce connectée est introduit préalablement dans un moule puis après surmoulage, le support 5 peut être retiré des métallisations ou être détruit. Le support peut aussi être désolidarisé des métallisations en étant altéré notamment par apport de chaleur lors du surmoulage dans un moule. L'adhésif est donc de préférence altérable assez rapidement (par exemple moins d'une minute ou le temps de l'injection quelques secondes) pour permettre le retrait du support juste après le surmoulage.

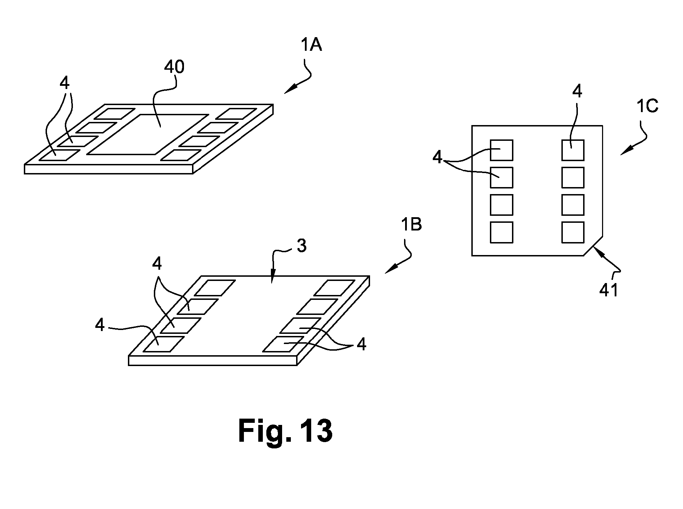

A la figure 13, les objets / boîtiers ont ici la forme de mini cartes 1A, 1B, 1C à contacts électriques 4 affleurant leur surface principale. La matière ou résine de moulage 7 constituant le corps isolant de la carte ou objet comprend une face 3 pouvant se situer au même niveau que les plages de contact 4. Autrement dit, les différentes métallisations sont espacées de matière isolante de moulage ayant le même niveau en surface (ou sensiblement au même niveau comme expliqué supra) que celui de l'isolant. Les métallisations affleurent sensiblement au même niveau que la matière de moulage sur la face 3.

Le cas échéant, selon les variantes de traitement de surface, il peut y avoir une légère différence de niveau entre les contacts ou interface et la matière de surmoulage.

Selon l'épaisseur déposée de la métallisation de traitement comme par exemple en Ni/Pd/Au, les plages de contact conducteurs peuvent affleurer la surface principale d'une valeur comprise entre 0 µm et de préférence 25µm voire 50 µm.

L'objet 1A peut comporter au centre une zone 40 pour une métallisation quelconque (contact, antenne...). L'objet 1B est parallélépipède et l'objet 1C comprend un détrompeur 41 en plus du précédent.

Grâce à l'invention, on peut agencer des constituants 4 électriques / électroniques ou des métallisations de l'objet avant surmoulage de manière que la surface externe des constituants 4 soit au même niveau (ou sensiblement) que la surface externe de la matière de moulage sur la face 3.

La tranche des boîtiers peut être légèrement inclinée pour favoriser le démoulage. A cet effet, la surface avant au contact du support est légèrement supérieure à la surface arrière opposée.

Grâce à l'invention on peut ainsi réduire au maximum l'épaisseur de ces objets. La puce peut être placée directement sur une des métallisations ou directement sur le support. Le nombre d'éléments superposés et constituant l'objet est réduit (absence de film support dans la constitution finale de l'objet contrairement à l'art antérieur).

Dans une autre variante concernant la fixation de la puce, celle-ci peut être collée directement sur le support de faible adhésivité, contrairement à la figure 3 ; Ainsi après retrait du support, la colle de fixation de la puce est au même niveau que celle de la surface avant 3 isolante (matière de moulage) du boitier ou sensiblement au même niveau que les métallisations.

Dans une autre variante alternative à ci-dessus, on peut même pousser la diminution de l'épaisseur du boitier à son maximum en déposant la puce directement sur le support de faible adhésivité ou un support enduit d'un adhésif décrit précédemment ; Ainsi après retrait du support, la face arrière de la puce se retrouve en surface du boitier après enlèvement du support.

Le cas échéant, un composant électronique comme un capteur d'empreinte peut venir en surface de la face 3 de l'objet car monté comme la puce 2 en surface directement contre le support (notamment de faible adhésivité).

Le cas échéant, les deux faces opposées de l'objet sont munies chacune d'un composant / élément surmoulé: l'invention peut prévoir de réaliser des plages de contact, autres métallisations ou autres constituants électriques/électroniques sur une face de l'objet comme décrit supra tandis qu'un autre composant, tel qu'un capteur d'empreinte ou autre, est réalisé sur la face opposée tout en affleurant la surface externe de la face. Ainsi, un composant tel qu'une puce électronique ou élément réalisant une fonction de capteur d'empreinte, peut être monté de manière à offrir une surface plane, notamment celle de capture d'empreinte vers l'extérieur.

Pour l'opération de moulage, cette surface plane susvisée peut venir au contact du plafond de la cavité EM au cours du moulage pour éviter un surmoulage par-dessus. Le cas échéant, on peut prévoir un film de protection amovible ou autre couche de protection sur le capteur d'empreinte pour éviter une pollution de la surface au cours du surmoulage.

Le moulage peut mettre en oeuvre différents procédés connus de l'homme de l'art réalisés à chaud ou à froid ou à réaction (RIM).

## Revendications

1. Procédé pour fabriquer un boîtier électronique (1, 1A, 1B, 1C) comprenant une puce (2) électronique dans le boîtier, une face (3) comportant au moins un jeu de métallisations conductrices (4) sur une face (3), ledit procédé comportant les étapes suivantes:
- fourniture ou réalisation d'au moins un jeu de métallisations (4) comprenant des plages et/ou pistes de circuit conductrices, sur un côté (9) d'un support (5);
- report et connexion d'une puce (2) à chaque jeu de métallisations,
- surmoulage de chaque puce (1) avec son jeu de métallisations, sur le support avec une matière (7) de moulage pour réaliser au moins un boîtier,
- séparation du boîtier de son support;
**caractérisé en ce que** le côté (9) du support (5) au contact des métallisations comporte un adhésif ou présente une adhésivité faible par nature ou altérable et **en ce que** le surmoulage est effectué à la dimension finale du boîtier.

2. Procédé selon la revendication précédente, **caractérisé en ce que** le surmoulage est réalisé de manière à c e que la surface externe des métallisations (4) soit au même niveau ou sensiblement au même niveau que la surface externe de la matière de moulage sur la face (3).

3. Procédé selon l'une des revendications précédentes, **caractérisé en ce que** le support est retiré des métallisations ou est détruit ou altéré au niveau de son adhésion notamment par apport de chaleur.

4. Procédé selon l'une des revendications précédentes, **caractérisé en ce que** le support (5) est désolidarisé des métallisations (4) par apport de chaleur lors du surmoulage dans un moule (M), le support portant les métallisations et au moins une puce (2) connectée étant introduits dans un moule.

5. Procédé selon l'une des revendications précédentes, **caractérisé en ce que** le support (5) est déterminé avec une pluralité de zones de réception de boîtiers.

6. Procédé selon l'une des revendications précédentes, **caractérisé en ce que** les deux faces opposées du boîtier sont munies chacune d'un composant /élément surmoulé et affleurant la surface de leur face respective, tels que des plages de contact sur une face et un capteur d'empreinte sur la face opposée.

7. Équipement de moulage (M, 14, 15) pour fabriquer un boîtier électronique (1A, 1B, 1C) comportant une puce (2) électronique, dont une face (3) comprend au moins des métallisations conductrices 4), selon le procédé de l'une des revendications 1 à 6, ledit équipement comportant:
- une partie inférieure pour recevoir et positionner un support (5) adhésif ou de faible adhésivité, comprenant au moins un jeu de métallisations (4) comportant des plages ou pistes de circuit conductrices et une puce (2) reportée et connectée électriquement (8) à chaque jeu de métallisations ;
- une partie supérieure comportant une pluralité de compartiments ((EM) de moulage configurés pour surmouler chaque puce (2) sur son support (5);
**caractérisé en ce que** chaque compartiment (EM) de moulage est aux dimensions ou formes finales du boîtier.

8. Équipement de moulage selon la revendication précédente, **caractérisée en ce qu'il** est configuré pour séparer le support (5) lors de l'ouverture du moule (M), des moyens de maintien ou de traction exerçant une force de séparation sur le support lors de l'ouverture du moule et **en ce qu'**il comprend des éjecteurs (14) pour éjecter les boîtiers (1A, 1B, 1C) de leur cavité après ouverture du moule.

9. Boîtier électronique (1, 1, 1B, 1C) obtenu par le procédé selon l'une des revendications 1 à 6 ou l'équipement de moulage selon l'une des revendications 7 à 8.
